# EUROPEAN PATENT APPLICATION

(11) **EP 4 501 701 A1**
(43) Date of publication of application: **05.02.2025**
(21) Application number: 22933877.7
(22) Date of filing: 28.03.2022
(51) Int. Cl.: B60L 58/12

(54) **BATTERY CONTROL METHOD AND BATTERY CONTROL DEVICE**

(71) Applicant: NISSAN MOTOR CO., LTD., Kanagawa 221-0023 (JP)
(72) Inventor: TANIGUCHI, Ikuhiro, Atsugi-shi, Kanagawa 243-0123 (JP); YOSHIOKA, Yoshiaki, Atsugi-shi, Kanagawa 243-0021 (JP); OGAWA, Hiroshi, Atsugi-shi, Kanagawa 243-0021 (JP)
(74) Representative: Grünecker Patent- und Rechtsanwälte PartG mbB
(86) International application number: PCT/JP2022/014974
(87) International publication number: WO 2023/187892

(57) **Abstract**

A method of controlling a battery 3 including a plurality of cells 1 is executed by a processor. The method includes detecting voltages of the plurality of cells 1; calculating a voltage difference between a highest voltage and a lowest voltage of the plurality of cells 1 based on the detected voltages; and executing an output restriction on the battery 3 when the voltage difference is equal to or greater than a predetermined first voltage difference threshold value.

## Description

### Technical Field

The present invention relates to a battery control method and a battery control device.

### Background Art

A conventional battery pack control device is known that includes a plurality of first voltage detection means that are connected to unit cells that constitute a battery pack to detect the voltages of the unit cells; a second voltage detection means that detects the total voltage of the battery pack; and a control means that selects either the voltage of each unit cell or the total voltage of the battery pack and controls the power of the battery pack according to the selected voltage (e.g., Patent Document 1). The battery pack control device described in Patent Document 1 calculates a voltage difference between an average voltage (V1) calculated from the total voltage of a battery 3 and a lowest voltage (V2) of each unit cell, and when the voltage difference is greater than a threshold value (C1), selects the lowest voltage (V2) and executes an output restriction according to the selected lowest voltage (V2) to prevent over-discharging.

### Prior Art Document

### Patent Document

Patent Document 1: Japanese Patent Application Publication No. 2010-226792

### Summary of Invention

### Problems to be solved by Invention

In a battery including a plurality of cells (battery cells), the temperature of each cell may vary depending on its position. For example, when the temperature of a certain cell becomes lower than the temperatures of other cells, the voltage of the lower temperature cell drops even though that cell is not abnormal. If the above-described conventional battery pack control device is used in such a battery environment, a large output restriction will be executed to prevent over-discharging due to the lowest voltage of the lower temperature cell. In other words, there is a problem in that an unnecessarily large output restriction is imposed on normal cells.

A problem to be solved by the present invention is to provide a battery control method and a battery control device that can prevent an unnecessarily large output restriction from being imposed on normal cells.

### Means for Solving Problems

To solve the above-described problem, the present invention includes: detecting voltages of a plurality of cells; calculating a voltage difference between a highest voltage and a lowest voltage of the plurality of cells based on the detected voltages; and executing an output restriction on a battery when the voltage difference is equal to or greater than a predetermined first voltage difference threshold value,.

### Effects of Invention

According to the present invention, it is possible to prevent an unnecessarily large output restriction from being imposed on normal cells.

### Brief Description of Drawings

FIG. 1 is a block diagram of a battery control system according to an embodiment of the present invention.
FIG. 2 is a side view of a vehicle.
FIG. 3 is a flowchart illustrating a control flow of an LBC and a vehicle controller.
FIG. 4 includes graphs illustrating (a) voltage characteristics and (b) SOC characteristics of a battery.
FIG. 5 is a graph illustrating a relationship between an output restricting threshold value and a restriction value in another embodiment of the present invention.
FIG. 6 is a flowchart illustrating a control flow of an LBC and a vehicle controller.

### Mode(s) for Carrying Out the Invention

### <<First Embodiment»

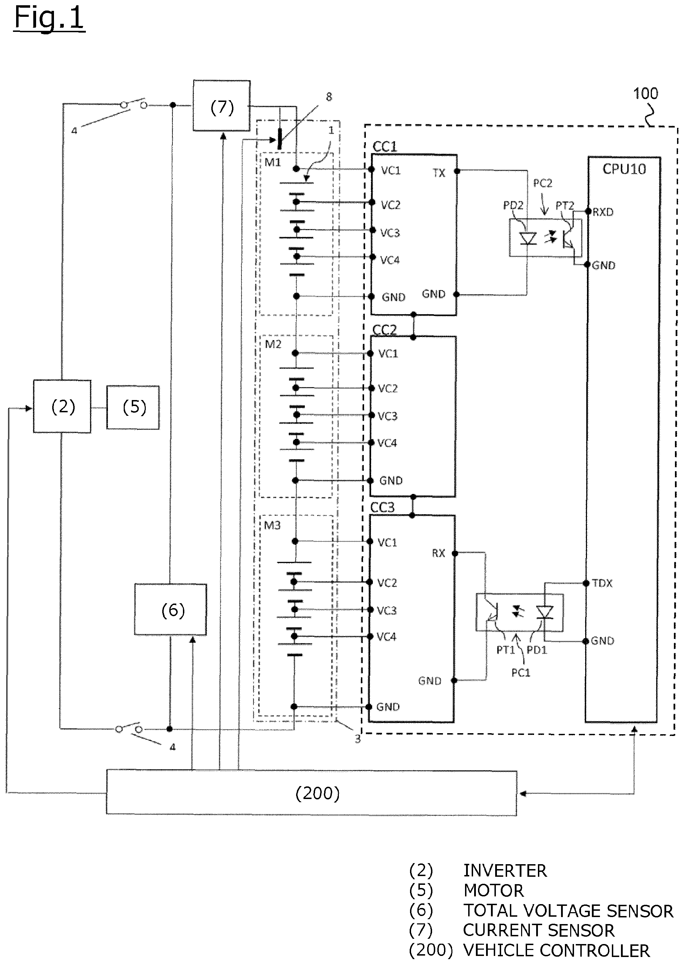

An embodiment of a battery control method and a battery control device according to the present invention will be described below with reference to the drawings. FIG. 1 is a block diagram of a battery control system according to the embodiment of the present invention. The battery control system includes a battery 3 including a plurality of cells (batteries) 1, an inverter 2, relay switches 4, a motor 5, a total voltage sensor 6, a current sensor 7, a temperature sensor 8, a lithium ion battery controller (LBC) 100, and a vehicle controller 200. A device including at least the battery controller 100 and the vehicle controller 200 corresponds to a "battery control device" of the present invention, and a control process(es) performed by the battery controller 100 and the vehicle controller 200 corresponds to a "battery control method" of the present invention.

The battery 3 has battery modules M1, M2, and M3, each of which has n cells (batteries) 1 (n is any positive integer, n = 4 in the example illustrated in FIG. 1) connected in series as one unit. As the cell 1, a lithium ion battery is used, for example. The battery 3 is a secondary battery that can be charged by a charging device external to a vehicle, and when a charging cable is connected to the vehicle, the battery 3 is electrically connected to the charging device external to the vehicle in a chargeable state. The battery 3 is also connected to the motor 5 via the inverter 2, the battery 3 is discharged when the motor 5 is in power running, and the battery 3 is charged when the motor 5 is in regeneration. Note that the number of battery modules is not limited to three, and may be one, two, four or more.

The three battery modules M1 to M3 are connected in series, and the motor 5 for an electric vehicle or the like is connected to both ends of the series via the inverter 2. The inverter 2 is a power conversion circuit that converts power between the battery 3 and the motor 5.

The relay switches 4 are turned on and off to turn on and off the main power supply, and are connected between the battery 3 and the motor 5 and inverter 2.

The total voltage sensor 6 is a sensor that is connected between the terminals of both poles of the battery 3 to detect the voltage of the battery 3. The current sensor 7 is connected between the battery 3 and the inverter 2 to detect the current output from the battery 3. The temperature sensor 8 is attached to the battery 3 to detect the temperature of the battery 3. Note that the temperature sensor 8 includes a plurality of temperature sensors provided at a plurality of points on the battery 3, and the average temperature of the detected values from the plurality of temperature sensors is regarded as the detected temperature of the battery 3. The total voltage sensor 6, the current sensor 7, and the temperature sensor 8 detect the total voltage, current, and temperature of the battery 3 in response to commands from the battery controller 100 and/or the vehicle controller 200, and transmit the detection results to the battery controller 100 and/or the vehicle controller 200.

The battery controller 100 is a controller (processor) that manages the state of the battery 3 and controls charging and discharging of the battery 3, and includes cell controllers CC1, CC2, and CC3, photocouplers PC1 and PC2, and a battery controller (CPU) 10. The three cell controllers CC1, CC2, and CC3 monitor the battery capacities of their corresponding battery modules M1, M2, and M3 (specifically, voltages VC1 to VC4 of their unit cells). The input terminals VC1 to VC4 of each of the cell controllers CC1 to CC3 are connected to their corresponding cells 1 of the battery modules M1 to M3, and the cell controllers CC1 to CC3 are cascade-connected.

The CPU 10 transmits a command to detect the voltage of each cell 1 to the cell controllers CC1 to CC3 at a predetermined timing, and when receiving this command, the cell controllers CC1 to CC3 detect the voltage of each cell 1. The detected voltages are stored in a memory or the like (not illustrated) provided in each of the cell controllers CC1 to CC3.

The CPU 10 also transmits a command to the cell controllers CC1 to CC3 to read the voltage of each cell 1 at a predetermined timing, and when receiving this command, the cell controllers CC1 to CC3 read the detected voltages stored in the memory and transmit the detected voltages to the CPU 10.

The photocouplers PC1 and PC2 having electrical insulation properties are used for communication between the CPU 10 and the cell controllers CC1 to CC3. The photocouplers PC1 and PC2 respectively have photodiodes PD1 and PD2 which are light-emitting elements, and phototransistors PT1 and PT2 which are light-receiving elements.

So-called cascade communication method is used for communication between the cell controller CC2 and the CPU 10, in which no photocoupler is used, data transmitted from the CPU 10 to the cell controller CC3 is transmitted from the cell controller CC3 to the cell controller CC2, and is then transmitted from the cell controller CC2 to the cell controller CC1, and finally this data is transmitted from the cell controller CC1 to the CPU 10 via the photocoupler PC2.

The vehicle controller 200 is a controller (processor) that controls the entire vehicle, such as controlling the drive system including the motor 5 and controlling auxiliary systems such as lights. The vehicle controller 200, together with the battery controller 100, also controls the battery 3. For example, the vehicle controller 200 restricts the output torque of the motor by controlling the inverter 2 to prevent over-discharging or charging/discharging of the battery 3 depending on the state of charge (SOC) of the battery 3. Note that in the example of FIG. 1, the LBC 100 and the vehicle controller 200 are separate, but the LBC 100 and the vehicle controller 200 may be integrated into a single controller. In addition, the detection values of the total voltage sensor 6 , the current sensor 7, and the temperature sensor 8 may be output directly to the battery controller 100.

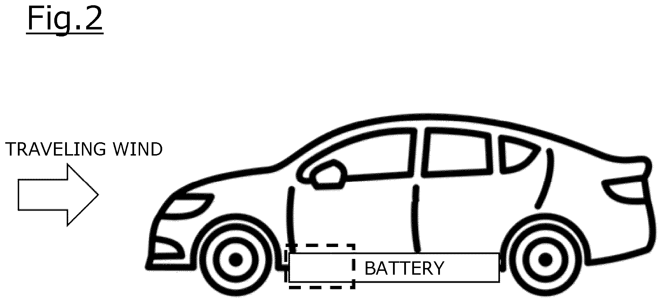

Next, the installation position of the battery 3 in the vehicle and the temperature of the battery 3 will be described with reference to FIG. 2. FIG. 2 is a side view of the vehicle, illustrating the position where the battery 3 is installed. As illustrated in FIG. 2, the battery 3 is provided on the chassis so as to run along the bottom surface of the vehicle. In order to ensure space within the vehicle cabin, the plurality of battery modules each having a flat shape are arranged in parallel along the bottom surface (travel surface) in the battery 3. While the vehicle is traveling, the vehicle is exposed to traveling wind. As illustrated in FIG. 2, the traveling wind blows from left to right on the sheet of FIG. 2. Therefore, the battery module M (in a dotted line area in FIG. 2) positioned at the front of the vehicle in the battery 3 installed outside the vehicle is likely to be exposed to the traveling wind, but the battery module M positioned at the rear of the vehicle is unlikely to be exposed. When the vehicle is operating at high load, such as when traveling at high speed (e.g., around 100 km/h), the traveling wind generated by the vehicle becomes stronger, and therefore the temperatures of the cells 1 included in the battery module at the front of the vehicle may become extremely lower than the temperatures of the cells 1 included in the other battery modules.

As a property of a secondary battery, when the temperature of a cell 1 is low, the internal resistance of the cell 1 becomes high, and therefore the voltage of the cell 1 (the voltage between the terminals of the cell 1) becomes low. Thus, in the battery 3 installed outside the vehicle, some of the battery modules are cooled by traveling wind and the like while the vehicle is traveling, and therefore even if the cooled cell 1 is not abnormal, its voltage will be lower than the voltages of the other cells.

The SOC of the battery 3 is calculated based on the average voltage and the lowest voltage of the battery 3. The average voltage of the battery 3 is the average value of the voltages of the plurality of cells 1, and the lowest voltage of the battery 3 is the lowest voltage among the voltages of the plurality of cells 1 (in the following description, the lowest voltage among the voltages of the plurality of cells 1 is also referred to as the "lowest voltage of the battery 3"). An example of a method of calculating the SOC of the battery 3 is as follows. The SOC of the cell 1 or the battery 3 has a correlation with the voltage, and the correlation between the SOC and the voltage is experimentally determined according to the performance of the battery, the degree of deterioration of the battery, and the like. When the SOC of the battery 3 is equal to or higher than SOC_{b}, an SOC corresponding to the average voltage of the battery 3 is calculated as the SOC of the battery 3. Then, when the SOC of the battery 3 is within a range of SOCₐ% or higher and lower than SOC_{b}, the SOC of the battery 3 is calculated from a predetermined arithmetic equation including the SOC corresponding to the average voltage of the battery 3 and an SOC corresponding to the lowest voltage of the battery 3. When the SOC of the battery 3 is lower than SOCₐ, the SOC corresponding to the lowest voltage of the battery 3 is calculated as the SOC of the battery 3.

In the method of calculating the SOC as described above, it is assumed that, for example, when the vehicle is traveling at high speed, some of the cells are cooled by traveling wind and the like, causing the temperatures of the cells to drop (hereinafter also referred to as low-temperature cell phenomenon). In such a situation, when the SOC of the battery 3 is high (SOC_{b} or higher), the SOC of battery 3 is calculated from the average voltage of the battery 3, and therefore even if the temperatures of some of the cells become low, there is little effect on the calculated value of the SOC. However, when the vehicle is traveling at high speed, the load on the battery 3 is large, and therefore the SOC decreases as the vehicle continues to travel at high speed. Further, the temperatures of the cells continue to decrease due to traveling wind, and the lowest voltage of the battery 3 becomes even lower. Then, when the SOC falls below SOCₐ, the SOC of the battery 3 is calculated from the lowest voltage of the battery 3, and therefore the calculated value of the SOC of the battery 3 may become extremely low. In other words, even when the battery 3 has a sufficient overall battery capacity, the temperatures of some of the cells are low, and the low-temperature cell voltages become low even though the low-temperature cells are not abnormal cells. Since the SOC of the battery 3 is calculated from the voltage of a low-temperature cell, the SOC of the battery 3 is calculated as a low value. When the calculated SOC is displayed on a display, the calculated value of the SOC becomes extremely low in a short period of time during high speed traveling, and the SOC displayed on the display also changes suddenly. Then, a passenger looking at the SOC display feels discomfort about the SOC display that drops in a short period of time.

Furthermore, when the calculated SOC is extremely low, the vehicle controller 200 executes a large output restriction to prevent the battery 3 from being over-discharged. Therefore, when the low-temperature cell phenomenon occurs during high speed traveling as described above, causing the SOC to drop, a large output restriction will be imposed. In this way, when the low-temperature cell phenomenon occurs, the temperature of a certain cell becomes lower than the temperatures of the other cells, and therefore a large restriction is imposed on the battery 3 even though no abnormality has occurred in the cells. In other words, an unnecessarily large output restriction is imposed on normal cells.

In particular, as illustrated in FIG. 1, when the plurality of cells 1 included in the battery 3 are connected in series, the amount of current output is greater than when the total number of cells 1 is not changed and they are connected in parallel in two. Therefore, when a sudden voltage drop occurs in a low-temperature cell due to the low-temperature cell phenomenon, there is a risk that an output restriction will be unnecessarily imposed to prevent over-discharging.

The battery control method and the battery control device according to the present embodiment execute an output restriction on the battery 3 according to the voltage difference between the highest and lowest voltages of the plurality of cells in order to avoid a large output restriction on the battery 3 and a sudden change in the SOC display, which are caused by decrease in temperatures of some of the cells as described above.

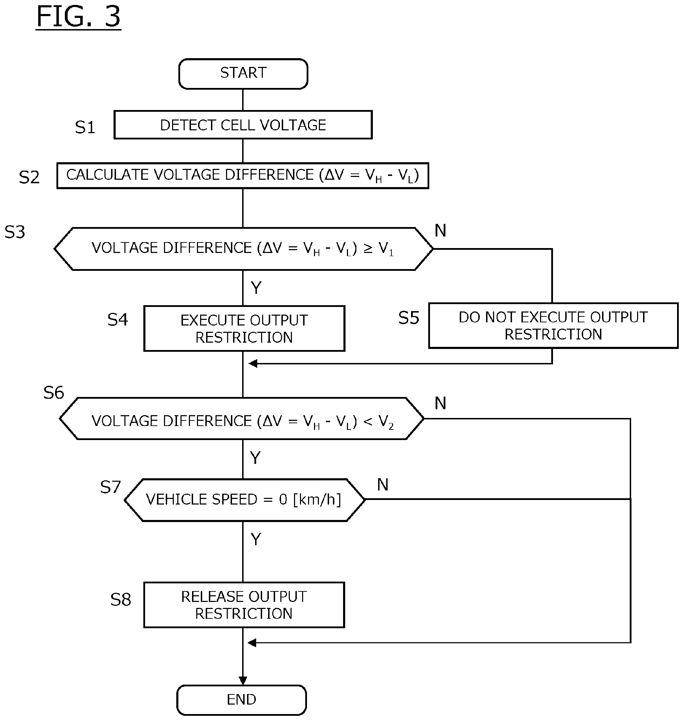

A method of controlling the battery controller 100 and the vehicle controller 200 will be described below with reference to FIG. 3. FIG. 3 is a flowchart illustrating a control flow of the battery controller 100 and the vehicle controller 200. Note that the control flow illustrated in FIG. 3 is repeatedly performed while the battery 3 is being discharged (while the vehicle is traveling). Further, when a main switch of the vehicle (a switch for putting the vehicle into a traveling state) is turned on, the battery controller 100 and the vehicle controller 200 start the control flow illustrated in FIG. 3.

In step S1, the battery controller 100 detects each of the voltages (cell voltages) of the plurality of cells 1 included in the battery 3. In step S2, the battery controller 100 calculates a voltage difference (ΔV) between the highest and lowest voltages of the plurality of cells. The battery controller 100 identifies the highest voltage (V_{H}) and the lowest voltage (V_{L}) from among the voltages of the plurality of cells 1, and calculates the voltage difference (ΔV) by calculating a difference (V_{H} - V_{L}) between the highest voltage (V_{H}) and the lowest voltage (V_{L}).

In step S3, the battery controller 100 compares the calculated voltage difference (ΔV) with a voltage difference threshold value (V₁), and determines whether or not the voltage difference (ΔV) is equal to or greater than the voltage difference threshold value (V₁). The voltage difference threshold value includes a threshold value for executing an output restriction (a restriction executing threshold value: Vi) and a threshold value for releasing the output restriction (a restriction releasing threshold value: V₂), and the restriction executing threshold value (V₁) is greater than the restriction releasing threshold value (V₂). In addition, when the voltage difference (ΔV) is equal to or greater than the restriction executing threshold value (V₁), the battery controller 100 outputs a restriction executing command to the vehicle controller 200 to execute the output restriction in step S4. When receiving the restriction executing command, the vehicle controller 200 executes the output restriction by making the discharge current from the battery 3 lower than the present current. Thus, when the voltage difference (ΔV) is equal to or greater than the restriction executing threshold value (V₁), the battery controller 100 and the vehicle controller 200 execute the output restriction on the battery 3.

Here, the battery controller 100 calculates the SOC of the battery 3 from the voltage of the battery 3 while performing the control flow of FIG. 3. The SOC of the battery 3 is calculated from the correlation between the voltage and SOC of the battery 3. Note that the SOC may be calculated from an accumulation of current when the battery 3 is charged and discharged. The battery controller 100 compares the calculated SOC with a lower limit SOC. The lower limit SOC is the lower limit of the allowable range of the SOC, which is set to prevent the battery 3 from being over-discharged. When the SOC of the battery 3 is equal to or lower than the lower limit SOC, the vehicle controller 200 executes a large output restriction to prevent the battery 3 from being over-discharged. Note that the output restriction to prevent over-discharging is a control that suppresses power consumption as much as possible while ensuring the minimum capacity necessary to reach the nearest charging facility, for example. Therefore, the restriction amount restricted by the output restriction imposed to prevent over-discharging is large.

The output restriction performed in the control flow of step S4 is smaller than the output restriction to protect the battery 3 from being over-discharged, in other words, the restriction amount of the output restriction in step S4 is smaller than the restriction amount of the output restriction for over-discharge protection. Even in other words, the output value (a discharge current, a discharge voltage, or an available output power) of the battery 3 after the output restriction in step S4 is higher than the output value of the battery 3 after the output restriction for over-discharge protection. For example, in a case where the output restriction is performed by current control, the current value restricted in the control flow of step S4 is smaller than the current value restricted by reaching the lower limit SOC (the current restriction amount is smaller). Note that the output restriction is not limited to by current control, but may be by voltage control.

When the voltage difference (ΔV) is less than the restriction executing threshold value (V₁), the battery controller 100 and the vehicle controller 200 do not execute the output restriction in step S5.

In step S6, the battery controller 100 compares the calculated voltage difference (ΔV) with the voltage difference threshold value (V₂), and determines whether or not the voltage difference (ΔV) is equal to or less than the voltage difference threshold value (V₂). The voltage difference threshold value (V₂) corresponds to the restriction releasing threshold value. When the voltage difference (ΔV) is less than the voltage difference threshold value (V₂), the battery controller 100 and the vehicle controller 200 perform the control flow of step S6. When the voltage difference (ΔV) is equal to or greater than the voltage difference threshold value (V₂), the battery controller 100 and the vehicle controller 200 end the control flow illustrated in FIG. 3.

In step S7, the vehicle controller 200 determines whether or not the vehicle speed of the vehicle is 0 [km/h]. When the vehicle speed of the vehicle is 0 km/h, the vehicle controller 200 releases the output restriction. Then, the battery controller 100 and the vehicle controller 200 end the control flow illustrated in FIG. 3. In this way, when the voltage difference (ΔV) during execution of the output restriction is less than the voltage difference threshold value (V₂) and the vehicle speed of the vehicle is 0 [km/h], in step S8, the battery controller 100 and the vehicle controller 200 release the output restriction. On the other hand, when the vehicle speed of the vehicle is not 0 [km/h], the battery controller 100 and the vehicle controller 200 end the control flow illustrated in FIG. 3. Note that in the determination in step S7, the preset vehicle speed threshold value is not limited to 0 [km/h], but may be a low speed such as 10 [km/h] or 20 [km/h],

Next, the output restriction when the low-temperature cell phenomenon occurs while the vehicle is traveling at high speed and the subsequent release of the output restriction will be described with reference to the above-described control flow. When the low-temperature cell phenomenon occurs while the vehicle is traveling at high speed, the temperatures of some of the cells become lower than the temperatures of the other cells, and the voltages of the low-temperature cells become lower accordingly, causing the voltage difference (ΔV) to become equal to or greater than the voltage difference threshold value (V₁). The vehicle controller 200 executes the output restriction through the control process of step S4. When the output restriction is executed, the discharge current of the battery 3 becomes low, and therefore the voltage difference (ΔV) during the output restriction becomes smaller than the voltage difference threshold value (V₁). After the control process of step S4 is performed, the output restriction is executed while the vehicle is traveling. Then, when the vehicle stops or is parked (the vehicle speed = 0 [km/h]), the output restriction is released.

In this way, the output restriction (the control process of step S4) reduces the discharge current from the low-temperature cells, which have lower temperatures than the other cells, and thus suppresses a decrease in the SOC of the low-temperature cells. As a result, during high speed traveling, the SOC reaches the lower limit SOC, so that the output of the battery 3 can be restricted before a large output restriction is reached. In addition, it is possible to prevent the calculated value of the SOC from becoming extremely low in a short period of time while the vehicle is traveling at high speed.

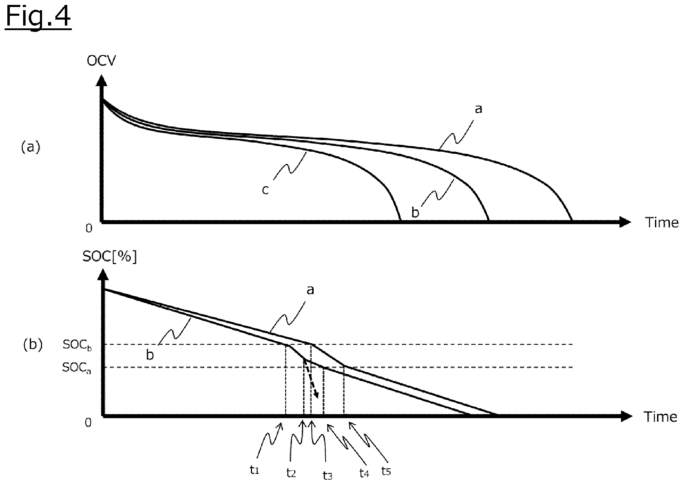

Next, changes over time in the voltage and SOC of the battery 3 while the vehicle is traveling (power-running) will be described with reference to FIG. 4. FIG. 4 includes graphs illustrating (a) voltage characteristics and (b) SOC characteristics of the battery 3. The voltage of the battery 3 is an open circuit voltage (OCV). Note that in the graphs of FIG. 4, for the purpose of explanation, the OCV is shown to be down to 0 V and the SOC to be down to 0%, but in actual vehicle control, the output of the battery 3 is controlled by the output restriction on the battery 3 so that the OCV and SOC of the battery 3 do not become zero.

When the vehicle starts traveling with the SOC of the battery 3 at 100%, the average voltage of the battery 3 gradually decreases over time as the battery 3 consumes power while the vehicle is traveling, as illustrated by a graph a in (a) of FIG. 4. The lowest voltage of the battery 3 changes with different characteristics depending on whether or not the low-temperature cell phenomenon occurs. When the low-temperature cell phenomenon does not occur, the lowest voltage of the battery 3 changes as illustrated by a graph b in (a) of FIG. 4. On the other hand, when the low-temperature cell phenomenon occurs, the lowest voltage of the battery 3 changes as illustrated by a graph c in (a) of FIG. 4. The voltage difference between the average voltage and the lowest voltage of the battery 3 increases as the SOC decreases, but the voltage difference when the low-temperature cell phenomenon occurs is greater than the voltage difference when the low-temperature cell phenomenon does not occur.

As illustrated by the graph a in (b) of FIG. 4, the SOC of the battery 3 gradually decreases over time. When the SOC of the battery 3 is equal to or higher than SOC_{b}, the SOC is calculated from the average voltage of the battery 3.

When the SOC reaches SOC_{b} (at time t₁ or ts in FIG. 4), the method of calculating the SOC of the battery 3 switches from a method of calculation using the average voltage to a method of calculation using the average voltage and the lowest voltage. Further, when the SOC reaches SOCₐ (at time t₄ or ts in FIG. 4), the method of calculating the SOC of the battery 3 switches from the method of calculation using the average voltage and the lowest voltage to a method of calculation using the lowest voltage.

When the low-temperature cell phenomenon does not occur, the SOC of the battery 3 changes as illustrated by the graph a. On the other hand, when the low-temperature cell phenomenon occurs, the SOC of the battery 3 changes as illustrated by the graph b. In the present embodiment, when the low-temperature cell phenomenon occurs, the power difference becomes equal to or greater than the voltage difference threshold value (V₁) at time t₂, and therefore the output restriction on the battery 3 is executed. Accordingly, the discharge current of the low-temperature cells is suppressed, so that the voltage drop of the low-temperature cells is suppressed, and the decrease in the SOC (calculated value) of the battery 3 is also suppressed. On the other hand, in a comparative example different from the present embodiment, the output restriction on the battery 3 is not executed even at time t₂. In addition, as the vehicle continues to travel at high speed, the temperatures of the low-temperature cells further decrease, and the lowest voltage of the battery 3 (the voltage of a low-temperature cell) further decreases. Therefore, as indicated by a dotted arrow, the calculated value of the SOC becomes extremely low in a short period of time.

As described above, the battery control method and battery control device according to the present embodiment includes: detecting voltages of a plurality of cells 1; calculating a voltage difference between a highest voltage and a lowest voltage of the plurality of cells 1 based on the detected voltages; and when the voltage difference is equal to or greater than a predetermined first voltage difference threshold value (corresponding to the restriction executing threshold value (Vi)), executing an output restriction on a battery 3. Thus, the output restriction on the battery is executed before a large output restriction that would prevent over-discharging is reached, so that it is possible to prevent an unnecessarily large output restriction from being imposed on normal cells.

Further, the battery control method and the battery control device according to the present embodiment includes: when the voltage difference during execution of the output restriction is less than a second voltage difference threshold value (corresponding to the restriction releasing threshold value (V₂)) and a vehicle speed of a moving body equipped with the battery 3 becomes equal to or less than a predetermined vehicle speed threshold value, releasing the output restriction. Thus, it is determined that the output restriction is no longer necessary, and it is possible to release the restriction. As a result, it is possible to minimize the period during which the operation of the moving body is restricted.

Furthermore, the battery control method and the battery control device according to the present embodiment includes: calculating an SOC of the battery 3, and when the calculated SOC is equal to or lower than a predetermined lower limit SOC, executing the output restriction on the battery 3. In addition, a first restriction amount of the output restriction to be executed when the voltage difference is equal to or greater than the first voltage difference threshold value is smaller than a second restriction amount of the output restriction to be executed when the calculated SOC is equal to or lower than the predetermined lower limit SOC. Thus, it is possible to execute a small output restriction on the battery 3 before a large output restriction is reached, thereby suppressing a decrease in the SOC of the battery 3.

Note that in the present embodiment, the battery controller 100 may set, as the lowest voltage of the battery 3, the voltage of cells positioned in a portion of the battery 3 that is exposed to traveling wind. When the vehicle equipped with the battery 3 is traveling, the portion that is exposed to traveling wind has been determined to some extent, and cells that are prone to the low-temperature cell phenomenon have also been determined. Therefore, the lowest voltage can be measured from the detected voltages of the cells in the portion that is exposed to traveling wind. Thus, since the low-temperature cell phenomenon caused by traveling wind occurs only in specific cells, voltage drops due to causes other than the decrease in temperature caused by the low-temperature cell phenomenon can be excluded by measuring only the specific cells to obtain the lowest voltage.

Note that as a modification example of the present embodiment, the battery controller 100 measures the SOC of each of the plurality of cells 1, and calculates an SOC difference between the average SOC and the lowest SOC of the plurality of cells 1 based on the measured SOCs. Then, when the calculated SOC difference is equal to or greater than a predetermined SOC difference threshold value, the vehicle controller 200 may execute the output restriction on the battery. Note that the battery controller 100 detects the voltages of the plurality of cells 1, and therefore can calculate, from each of the detected voltages, the SOC of the corresponding cell 1. Thus, even in a case where the battery 3 is composed of different types of cells, for example, in which the cells have different highest voltages in the battery 3, by using such a standardized SOC, the need for an output restriction can be determined using the same measured value.

Note that as a modification example of the present embodiment, the battery controller 100 detects temperatures at a plurality of detection points in the battery 3, and calculates the temperature difference between the highest and lowest temperatures of the plurality of cells 1 based on the detected temperatures. Then, the vehicle controller 200 may execute the output restriction on the battery 3 when the temperature difference is equal to or greater than a predetermined temperature difference threshold value. The highest and lowest temperatures of the plurality of cells 1 may be identified from the detection values of the plurality of temperature sensors installed in the battery 3. Alternatively, the vehicle controller 200 may calculate a temperature distribution of the battery 3 from the detection values of the temperature sensors, the ambient temperature of the battery 3, and the traveling state of the vehicle, and set the highest and lowest temperatures in the calculated temperature distribution as the highest and lowest temperatures of the plurality of cells 1. Thus, it is possible to determine whether or not an output restriction is necessary based on the temperature difference.

### <<Second Embodiment»

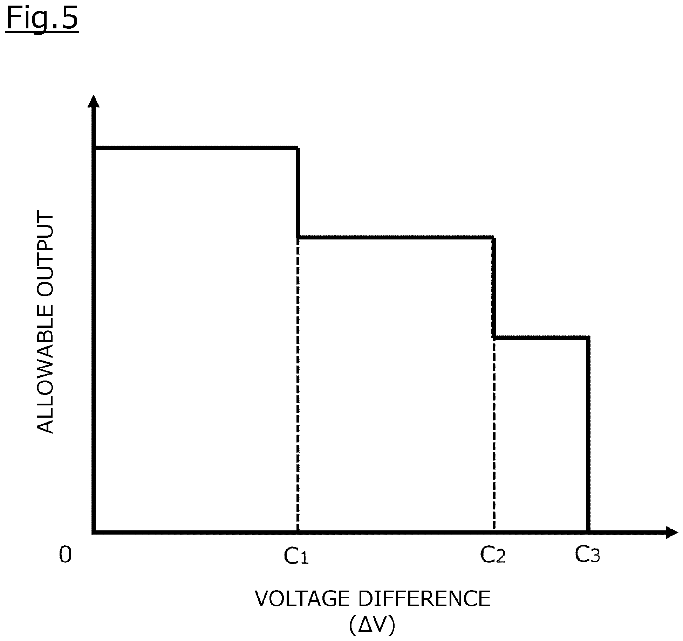

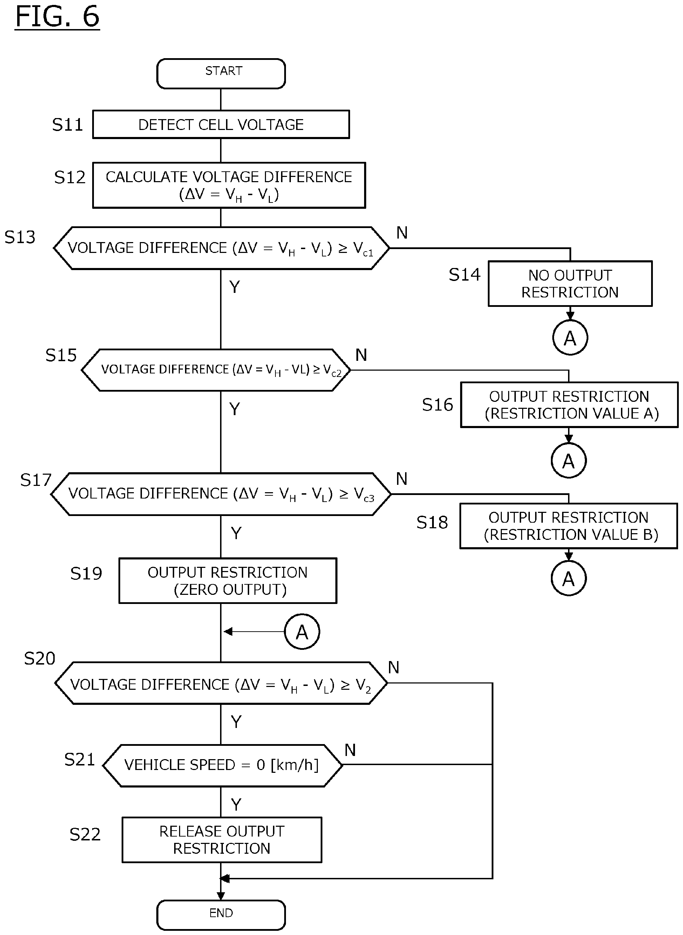

Next, a second embodiment will be described with reference to the drawings. FIG. 5 is a graph illustrating a relationship between output restricting threshold values (V_{c1}, V_{c2}, V_{c3}) and restriction values. FIG. 6 is a flowchart illustrating a control flow of the battery controller 100 and the vehicle controller 200. In the present embodiment, although some of the control by the battery controller 100 and the vehicle controller 200 is different, the configuration of the battery control system is similar to that of the first embodiment. Below, different parts in the second embodiment from the first embodiment will be described, parts having the same configuration as the first embodiment will be given the same reference numerals, and thus the description thereof will be omitted. In addition, for explanations of the same configuration and control, the descriptions in the first embodiment will be used as appropriate.

In the present embodiment, there are three threshold values V_{c1}, V_{c2}, and V_{c3} for executing an output restriction. The output restricting threshold values (V_{c1}, V_{c2}, V_{c3}) are threshold values to be compared with the voltage difference (ΔV), with the output restricting threshold value (V_{c1}) being the smallest and the output restricting threshold value (V_{c3}) being the largest. Further, when the voltage difference (ΔV) is equal to or greater than the output restricting threshold value (V_{c1}) and less than the output restricting threshold value (V_{c2}), a first stage of output restriction is executed to restrict the upper limit of the output of the battery 3 to restriction value A. Further, when the voltage difference (ΔV) is equal to or greater than the output restricting threshold value (V_{c2}) and less than the output restricting threshold value (V_{c3}), a second stage of output restriction is executed to restrict the upper limit of the output of the battery 3 to restriction value B (< restriction value A). Furthermore, when the voltage difference (ΔV) is equal to or greater than the output restricting threshold value (V_{c3}), the upper limit of the output of the battery 3 is restricted to zero. Specifically, the relationship between the output restricting threshold values (V_{c1}, V_{c2}, V_{c3}) and the restriction values is as illustrated in the graph of FIG. 5. Note that in FIG. 5, the vertical axis indicates the allowable output of the battery 3, and the horizontal axis indicates the voltage difference. Thus, a restriction amount set for the output restriction on the battery 3 increases as the voltage difference increases. In the graph of FIG. 5, the restriction amount corresponds to a difference between the maximum allowable output and the restriction value when no output restriction is imposed on the battery 3.

Next, a method of controlling the battery controller 100 and the vehicle controller 200 will be described with reference to FIG. 6. The control processes of steps S11 and S12 are the same as the control processes of steps S1 and S2 in the first embodiment.

In step S13, the calculated voltage difference (ΔV) is compared with the output restricting threshold value (V_{c1}) to determine whether or not the voltage difference (ΔV) is equal to or greater than the output restricting threshold value (V_{c1}). When the voltage difference (ΔV) is less than the output restricting threshold value (V_{c1}), the vehicle controller 200 does not execute the output restriction in step S14. The control flow proceeds to step S20.

If it is determined that the voltage difference (ΔV) is equal to or greater than the output restricting threshold value (V_{c1}), the voltage difference (ΔV) and the output restricting threshold value (V_{c2}) are compared in step S15 to determine whether or not the voltage difference (ΔV) is equal to or greater than the output restricting threshold value (V_{c2}). If it is determined that the voltage difference (ΔV) is not equal to or greater than the output restricting threshold value (V_{c2}), that is, when the voltage difference (ΔV) is equal to or greater than the output restricting threshold value (V_{c1}) and less than the output restricting threshold value (V_{c2}), the vehicle controller 200 executes the output restriction with restriction value A. The control flow then proceeds to step S20.

If it is determined that the voltage difference (ΔV) is equal to or greater than the output restricting threshold value (V_{c2}), the voltage difference (ΔV) and the output restricting threshold value (V_{c3}) are compared in step S17 to determine whether or not the voltage difference (ΔV) is equal to or greater than the output restricting threshold value (V_{c3}). If it is determined that the voltage difference (ΔV) is not equal to or greater than the output restricting threshold value (V_{c3}), that is, when the voltage difference (ΔV) is equal to or greater than the output restricting threshold value (V_{c2}) and less than the output restricting threshold value (V_{c3}), the vehicle controller 200 executes the output restriction with restriction value B. The control flow then proceeds to step S20.

If it is determined that the voltage difference (ΔV) is equal to or greater than the output restricting threshold value (V_{c3}), the vehicle controller 200 executes the output restriction so that the output of the battery 3 becomes zero in step S19. Note that in the control process of step S19, the upper limit during the output restriction may be a value greater than zero. The control processes of steps S20 to S22 are the same as the control processes of steps S6 to S8 according to the first embodiment. Then, the battery controller 100 and the vehicle controller 200 end the control flow illustrated in FIG. 6.

As described above, in the present embodiment, a restriction amount set for the output restriction on the battery 3 increases as the voltage difference between the highest and lowest voltages of the plurality of cells increases. Thus, it is possible to execute an output restriction with a restriction amount depending on the state of the voltage difference.

Note that the battery controller 100 and the vehicle controller 200 correspond to a "controller" of the present invention.

Note that the embodiments described above are described to facilitate understanding of the present invention, and are not described to limit the present invention. Therefore, the elements disclosed in the above embodiments are meant to include all design changes and equivalents that fall within the technical scope of the present invention.

### Description of Reference Numerals

- 1: Cell
- 2: Inverter
- 3: Battery
- 4: Relay switch
- 5: Motor
- 6: Total voltage sensor
- 7: Current sensor
- 8: Temperature sensor
- 100: Battery controller
- 200: Vehicle controller

## Claims

1. A method of controlling a battery including a plurality of cells executed by a processor, the method comprising:
detecting voltages of the plurality of cells;
calculating a voltage difference between a highest voltage and a lowest voltage of the plurality of cells based on the detected voltages; and
executing an output restriction on the battery when the voltage difference is equal to or greater than a predetermined first voltage difference threshold value.

2. The method of controlling a battery according to claim 1, wherein the voltage of the cell positioned in a portion of the battery exposed to traveling wind is set as the lowest voltage.

3. The method of controlling a battery according to claim 1 or 2, comprising
when the voltage difference during execution of the output restriction is less than a second voltage difference threshold value that is lower than the first voltage difference threshold value and a vehicle speed of a moving body equipped with the battery becomes equal to or less than a predetermined vehicle speed threshold value, releasing the output restriction.

4. The method of controlling a battery according to any one of claims 1 to 3, comprising:
measuring an SOC of each of the plurality of cells;
calculating an SOC difference between an average SOC and a lowest SOC of the plurality of cells based on the measured SOC; and
executing an output restriction on the battery when the SOC difference is equal to or greater than a predetermined SOC difference threshold value.

5. The method of controlling a battery according to any one of claims 1 to 4, comprising:
detecting temperatures at a plurality of detection points in the battery;
calculating a temperature difference between a highest temperature and a lowest temperature of the plurality of cells based on the detected temperatures; and
executing an output restriction on the battery when the temperature difference is equal to or greater than a predetermined temperature difference threshold value.

6. The method of controlling a battery according to any one of claims 1 to 5, wherein a restriction amount set for an output restriction on the battery increases as the voltage difference increases.

7. The method of controlling a battery according to any one of claims 1 to 6, comprising:
calculating an SOC of the battery; and
executing an output restriction on the battery when the calculated SOC is equal to or less than a predetermined lower limit SOC,
wherein a first restriction amount of the output restriction to be executed when the voltage difference is equal to or greater than the first voltage difference threshold value is smaller than a second restriction amount of the output restriction to be executed when the calculated SOC is equal to or lower than the predetermined lower limit SOC.

8. A battery control device comprising:
a battery including a plurality of cells; and
a controller configured to control an output of the battery,
wherein the controller is configured to:
detect voltages of the plurality of cells;
calculate a voltage difference between a highest voltage and a lowest voltage of the plurality of cells based on the detected voltages; and
execute an output restriction on the battery when the voltage difference is equal to or greater than a predetermined first voltage difference threshold value.

9. The battery control device according to claim 8, wherein the voltage of the cell positioned in a portion of the battery exposed to traveling wind is set as the lowest voltage.

10. The battery control device according to claim 8 or 9, wherein
the controller is configured such that when the voltage difference during execution of the output restriction is less than a second voltage difference threshold value that is lower than the first voltage difference threshold value and a vehicle speed of a moving body equipped with the battery becomes equal to or less than a predetermined vehicle speed threshold value, the controller releases the output restriction.

11. The battery control device according to any one of claims 8 to 10, wherein
the controller is configured to:
measure an SOC of each of the plurality of cells;
calculate an SOC difference between an average SOC and a lowest SOC of the plurality of cells based on the measured SOC; and
execute an output restriction on the battery when the SOC difference is equal to or greater than a predetermined SOC difference threshold value.

12. The battery control device according to any one of claims 8 to 11, wherein
the controller is configured to:
detect temperatures at a plurality of detection points in the battery;
calculate a temperature difference between a highest temperature and a lowest temperature of the plurality of cells based on the detected temperatures; and
execute an output restriction on the battery when the temperature difference is equal to or greater than a predetermined temperature difference threshold value.

13. The battery control device according to any one of claims 8 to 12, wherein the controller is configured such that a restriction amount set for an output restriction on the battery increases as the voltage difference increases.

14. The battery control device according to any one of claims 8 to 13, wherein
the controller is configured to:
calculate an SOC of the battery; and
execute an output restriction on the battery when the calculated SOC is equal to or less than a predetermined lower limit SOC,
wherein a first restriction amount of the output restriction to be executed when the voltage difference is equal to or greater than the first voltage difference threshold value is smaller than a second restriction amount of the output restriction to be executed when the calculated SOC is equal to or lower than the predetermined lower limit SOC.
